# EUROPÄISCHE PATENTANMELDUNG

(11) **EP 2 728 984 A1**
(43) Veröffentlichungstag der Anmeldung: **07.05.2014**
(21) Anmeldenummer: 12191429.5
(22) Anmeldetag: 06.11.2012
(51) Int. Cl.: H05K 5/02, H02B 1/38

(54) **Gehäuse mit einem ersten Gehäuseteil und einem zweiten Gehäuseteil aufweisend ein Zapfengelenk**

(71) Anmelder: Siemens Aktiengesellschaft, 80333 München (DE)
(72) Erfinder: Bergmann, Martin, 92253 Schnaittenbach (DE); Blei, Hendrik, 90491 Nürnberg (DE); Ringer, Ulrich, 92224 Amberg (DE)

(57) **Zusammenfassung**

Die Erfindung betrifft ein Gehäuse (100) mit einem ersten Gehäuseteil (1) und einem zweiten Gehäuseteil (2), aufweisend ein Zapfengelenk (10) mit einem Zapfen (11a) und eine den Zapfen (11a) zumindest teilweise umschließende Gabel (11b), wobei die Gabel (11b) einen ersten Schenkel (21) und einen zweiten Schenkel (22) aufweist, der Zapfen (11a) ist dabei am ersten Gehäuseteil (1) und die Gabel (11b) am zweiten Gehäuseteil (2) angeordnet, wobei auf einer Mantelfläche des Zapfens (11a) eine Erhebung (41,42) und auf einer Schenkelinnenseite (21a) eines Schenkels (21,22) eine Gegenerhebung (51,52) derart angeordnet sind, dass der zweite Gehäuseteil (2) von einer ersten Stellung (31) in eine zweite Stellung (32) durch eine Drehbewegung schwenkbar ist, wobei bei der Drehbewegung (3) die Gabel (11b) um den Zapfen (11a) zur Erreichung der zweiten Stellung (32) bewegbar ist, wobei die Erhebung (41,42) und die Gegenerhebung (51,52) sich gegenseitig annähern damit die Gegenerhebung (51,52) die Erhebung (41,42) überspringen kann und damit der zweite Gehäuseteil (2) die zweite Stellung (32) erreicht hat.

## Beschreibung

Die Erfindung betrifft ein Gehäuse mit einem ersten Gehäuseteil und einem zweiten Gehäuseteil, aufweisend ein Zapfengelenk mit einem Zapfen und eine den Zapfen teilweise umschlie-βende Gabel, wobei die Gabel einen ersten Schenkel und einen zweiten Schenkel aufweist, der Zapfen ist dabei am ersten Gehäuseteil und die Gabel am zweiten Gehäuseteil angeordnet.

Ein derartiges Gehäuse ist beispielsweise aus der EP 1 439 277 B1 bekannt. Im Sinne der Erfindung soll unter Gehäuse vorzugsweise eine Umhausung für eine elektronische Baugruppe verstanden werden. Der erste Gehäuseteil könnte beispielsweise als ein Grundgehäuse ausgestaltet sein und der zweite Gehäuseteil könnte beispielsweise als eine schwenkbare Klappe ausgestaltet sein.

Es ist Aufgabe der Erfindung bei einem vorgegebenen Grundgehäuse und einem vorgegebenen Bauraum eine schwenkbare, abnehmbare Klappe zu realisieren, wobei die Klappe Öffnungsstellungen aufweisen soll.

Für das Gehäuse nach dem Oberbegriff des Patentanspruchs 1 wird die Aufgabe dadurch gelöst, dass auf einer Mantelfläche des Zapfens eine Erhebung und auf einer Schenkelinnenseite eines Schenkels eine Gegenerhebung derart angeordnet sind, dass der zweite Gehäuseteil von einer ersten Stellung in eine zweite Stellung durch eine Drehbewegung schwenkbar ist, wobei bei der Drehbewegung die Gabel um den Zapfen zur Erreichung der zweiten Stellung bewegbar ist, wobei die Erhebung und die Gegenerhebung sich gegenseitig annähern damit die Gegenerhebung die Erhebung überspringen kann und damit der zweite Gehäuseteil die zweite Stellung erreicht hat. Dadurch dass der zweite Gehäuseteil, vorzugsweise ausgestaltet als eine Frontklappe, mit einer Gabel ausgestaltet ist, welche zwischen ihren Schenkeln somit eine Öffnung aufweist, ist der zweite Gehäuseteil vor dem ersten Gehäuseteil abnehmbar. Die Gabel kann also auf den Zapfen aufgeschoben werden, wobei sich die Schenkel leicht spreizen und wenn sie vollständig auf dem Zapfen aufliegen wieder zusammenziehen. Das Zusammenspiel der Erhebung auf dem Zapfen und der Gegenerhebung auf der Innenseite eines Schenkels ermöglicht vorzugsweise eine Öffnungsstellung, bei der der zweite Gehäuseteil immer noch mit dem ersten Gehäuseteil verbunden ist und beispielsweise wie eine geöffnete Klappe in einem bestimmten Winkel von dem ersten Gehäuseteil absteht.

In einer vorteilhaften Ausgestaltung weist das Gehäuse mit seinem ersten Gehäuseteil eine Vorderseite, eine Rückseite, eine Oberseite, eine Unterseite, eine erste Seitenwand und eine zweite Seitenwand auf, wobei das Zapfengelenk als ein erster Zapfen und ein zweiter Zapfen ausgestaltet ist, dabei sind der erste Zapfen und der zweite Zapfen auf einer Drehachse gegenüberliegend angeordnet, die Drehachse ist wiederum im Bereich einer Kante, welche durch die Angrenzung der Oberseite an die Vorderseite gebildet ist, angeordnet. In dieser Ausgestaltung weist das erste Gehäuseteil zwei Zapfen zur Aufnahme jeweils einer Gabel auf, wodurch die Stabilität in der Verbindung zwischen erstem Gehäuseteil und zweitem Gehäuseteil erhöht wird.

Dazu sind am zweiten Gehäuseteil eine erste Gabel und eine zweite Gabel angeordnet, und die erste Gabel umschließt zumindest teilweise den ersten Zapfen und die zweite Gabel umschließt zumindest teilweise den zweiten Zapfen. Da die beiden Gabeln jeweils eine Öffnung aufweisen, kann der zweite Gehäuseteil, beispielsweise eine Frontklappe, zum Abnehmen der Frontklappe von dem ersten Gehäuseteil weggeschnappt oder zum Anbringen der Frontklappe wieder auf dem ersten Gehäuseteil aufgeschnappt werden.

Um bei dem Gehäuse, für den zweiten Gehäuseteil, vorzugsweise eine Frontklappe, bezogen auf den ersten Gehäuseteil eine definierte Öffnungsstellung zu erreichen, ist es von Vorteil wenn die Erhebung auf dem Zapfen ausgehend von der Anordnung der Gabel in der ersten Stellung um den Zapfen derart angeordnet ist, dass bei einer Schwenkbewegung des zweiten Gehäuseteils von dem ersten Gehäuseteil weg zur Erreichung der zweiten Stellung sich ein Endpunkt von dem ersten Schenkel von der Erhebung wegbewegt und sich ein Endpunkt von dem zweiten Schenkel auf die Erhebung zu bewegt. Vorteilhafter Weise werden demnach die Gegenerhebung bzw. Gegenerhebungen auf der Innenseite des zweiten Schenkels angeordnet.

Um ein Öffnen des Gehäuses durch Wegschwenken des zweiten Gehäuseteils von dem ersten Gehäuseteil möglichst komfortabel zu gestalten, ist eine erste Erhebung und eine zweite Erhebung auf dem Zapfen angeordnet und zwischen der ersten Erhebung und der zweiten Erhebung ist eine Nut parallel zur Drehachse in der Mantelfläche des Zapfens angeordnet. Bei einem Überspringen der Gegenerhebung über die erste Erhebung würde die Gegenerhebung in die Nut spürbar einrasten und man hätte eine erste Zwischenstellung zwischen einer endgültigen Öffnungsstellung erreicht.

Besonders vorteilhaft ist es, wenn die Erhebungen als Spitznocken ausgestaltet sind. Durch den steilen Anstieg einer Spitznocke muss eine deutlich höhere Kraft aufgewendet werden um mit der Gegenerhebung die Erhebung zu überwinden damit schließlich die Gegenerhebung in der Nut eine erste Ruhestellung erreicht hat.

Vorteilhafter Weise ist dabei die Gegenerhebung an der Schenkelinnenseite auf dem zweiten Schenkel angeordnet.

Eine weitere Optimierung für das Erreichen von sicheren Öffnungsstellungen ist gegeben, wenn eine erste Gegenerhebung und eine zweite Gegenerhebung hintereinander an der Schenkelinnenseite auf dem zweiten Schenkel angeordnet sind.

Die Gegenerhebung ist dabei derart ausgestaltet, dass eine Kraft zum Erreichen der zweiten Stellung ausgehend von der ersten Stellung kleiner ist als eine Kraft zum Erreichen der ersten Stellung ausgehend von der zweiten Stellung. Hierzu könnten die Gegenerhebung beispielsweise unterschiedliche Winkel aufweisen. Die Winkel bewirken, beispielsweise bei der Öffnung einer Frontklappe unterschiedliche Kräfte, da die Erhebungen über diese Gegenerhebungen gleiten müssen. Vorzugsweise soll bei einem Öffnen einer Frontklappe die Kraft gering gehalten werden. Hier wäre der Winkel flacher ausgeführt. Bei einem Schließen der Frontklappe erfolgt die Winkelstellung umgekehrt, d.h. die Winkel sind steiler ausgebildet und die Kraft zum Schließen ist damit größer.

Damit eine Spreizung der Schenkel der Gabel nicht zu einem Materialbruch führt, weist die Gabel eine Materialausnehmung auf um einen vorgebbaren Dehnungswert des Gabel-Materials bei einer Spreizung der Schenkel nicht zu überschreiten. Eine sichelförmige Materialausnehmung in der Gabel wäre vorteilhaft.

Die Zeichnung zeigt ein Ausführungsbeispiel des Gehäuses mit einem ersten Gehäuseteil und einem zweiten Gehäuseteil, wobei das Ausführungsbeispiel vorzugsweise als ein Grundgehäuse mit einer abnehmbaren Frontklappe dargestellt ist. Dieses Grundgehäuse mit der abnehmbaren Frontklappe wird vorteilhafter Weise für elektronische Flachbaugruppen aus der Automatisierungstechnik eingesetzt. Es zeigt
- FIG 1: ein Gehäuse für eine Automatisierungsbaugruppe,
- FIG 2: eine abnehmbare Frontklappe für das Gehäuse der Automatisierungsbaugruppe,
- FIG 3: eine Detaildarstellung des Zapfengelenkes der Automatisierungsbaugruppe aus FIG 1,
- FIG 4: eine weitere Detaildarstellung der Zapfen der Automatisierungsbaugruppe und
- FIG 5: eine mögliche Ausgestaltung einer Gabel in einer Schnittdarstellung, wobei die Gabel einen Zapfen umschließen kann.

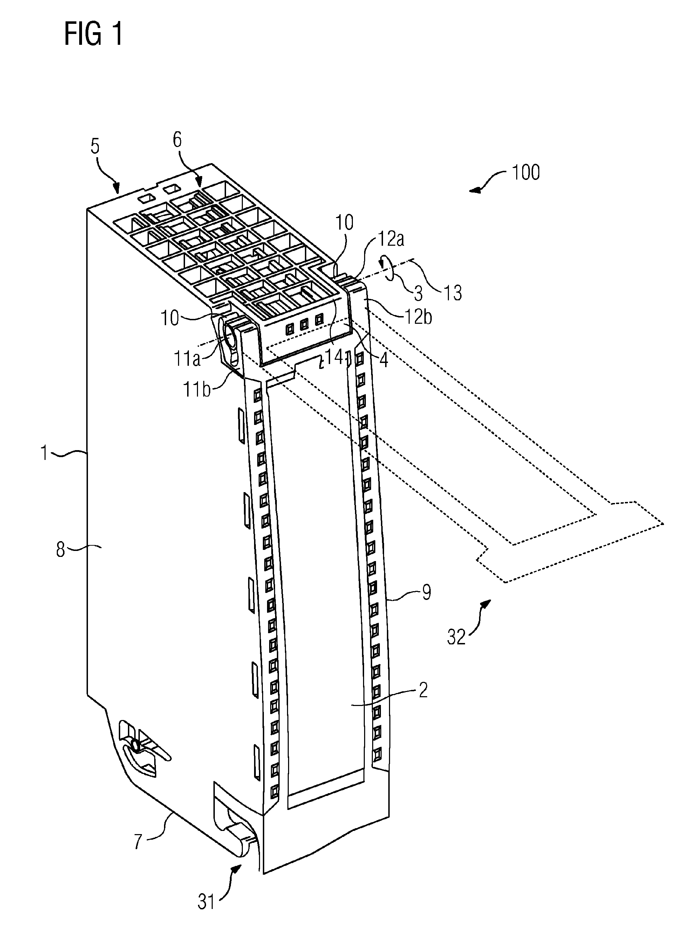

Gemäß FIG 1 ist ein Gehäuse 100 mit einem ersten Gehäuseteil 1 und einem zweiten Gehäuseteil 2 dargestellt. In dieser besonderen Ausgestaltung als ein Gehäuse für eine Automatisierungsbaugruppe ist der zweite Gehäuseteil 2 als eine abnehmbare Frontklappe für die Automatisierungsbaugruppe ausgestaltet. Das Gehäuse ist quaderförmig ausgestaltet und weist eine Vorderseite 4, eine Rückseite 5, eine Oberseite 6, eine Unterseite 7, eine erste Seitenwand 8 und eine zweite Seitenwand 9 auf. Die Vorderseite 4 wird durch den abnehmbaren zweiten Gehäuseteil 2 abgedeckt. Da es sich hier um eine Automatisierungsbaugruppe handelt, sind links und rechts von der abnehmbaren Frontklappe LED-Lichter angeordnet zur Statusanzeige von unterschiedlichen Ein- oder Ausgangskanälen.

Der erste Gehäuseteil 1 und der zweite Gehäuseteil wirken derart zusammen, dass ein Zapfengelenk 10 an einer oberen Kante 14 des Gehäuses 100 ausgebildet ist. Das Zapfengelenk 10 ist als ein erster Zapfen 11a und als ein zweiter Zapfen 12a ausgestaltet, dabei sind der erste Zapfen 11a und der zweite Zapfen 12a auf einer Drehachse 13 gegenüberliegend angeordnet, die Drehachse 13 ist wiederum im Bereich der Kante 14 angeordnet, welche durch die Angrenzung der Oberseite 6 an die Vorderseite 4 gebildet ist.

Damit der zweite Gehäuseteil 2 abnehmbar ist, sind am zweiten Gehäuseteil 2 eine erste Gabel 11b und eine zweite Gabel 12b angeordnet, dabei umschließt die erste Gabel 11b den ersten Zapfen 11a zumindest teilweise und die zweite Gabel 12b umschließt den zweiten Zapfen zumindest teilweise. Das teilweise Umschließen des ersten Zapfens 11a und des zweiten Zapfens 12a durch die jeweilige Gabel 11b,12b ergibt sich dadurch, dass die erste Gabel 11b und die zweite Gabel 12b jeweils eine Öffnung aufweisen, wodurch die Gabeln 11b,12b auf die Zapfen 11a,12a aufgeschnappt werden können. Durch diese Ausgestaltung ist der zweite Gehäuseteil 2 abnehmbar von dem ersten Gehäuseteil 1. Der zweite Gehäuseteil 2 befindet sich im geschlossenen Zustand in einer ersten Stellung 31. Wird auf den zweiten Gehäuseteil 2 eine Schwenkbewegung ausgeführt, welches zu einer Drehbewegung 3 um die Drehachse 13 führt, so kann der zweite Gehäuseteil 2 von der ersten Stellung 31 in die zweite Stellung 32 gebracht werden.

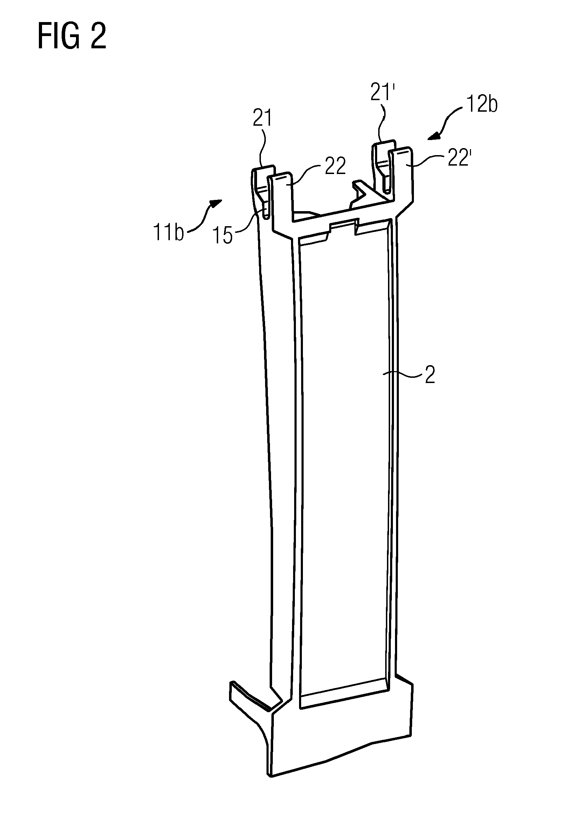

Gemäß FIG 2 ist das abnehmbare zweite Gehäuseteil 2 dargestellt. An einem oberen Ende des zweiten Gehäuseteils 2 ist jeweils die erste Gabel 11b und die zweite Gabel 12b angeordnet. Eine Gabel 11b,12b besteht jeweils aus einem ersten Schenkel 21 bzw. aus einem weiteren ersten Schenkel 21' und aus einem zweiten Schenkel 22 bzw. aus einem weiteren zweiten Schenkel 22'. Die erste Gabel 11b und die zweite Gabel 12b sind wiederum gabelförmig an einem Hauptteil des zweiten Gehäuseteils 2 angeordnet.

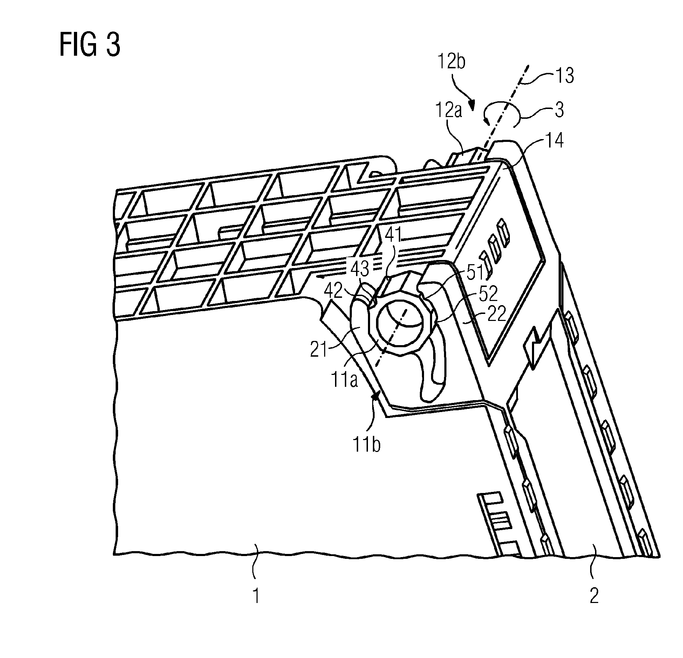

Mit der FIG 3 ist eine Detaildarstellung der Automatisierungskomponente aus FIG 1 wiedergegeben. Es zeigt ausschnittsweise den ersten Gehäuseteil 1 und den zweiten Gehäuseteil 2. An dem ersten Gehäuseteil 1 sind zur Platzeinsparung der erste Zapfen 11a und der zweite Zapfen 12a im Bereich der Kante 14 nach Innen versetzt angeordnet. Die erste Gabel 11b umschließt den ersten Zapfen 11a mit ihrem ersten Schenkel 21 und ihrem zweiten Schenkel 22. Ebenso umschließt die zweite Gabel 12b den zweiten Zapfen 12a. Parallel zu der Kante 14 ist die Drehachse 13 gestrichelt eingezeichnet. Um die Drehachse 13 kann zum Wegschwenken des zweiten Gehäuseteils 2 von dem ersten Gehäuseteil 1 eine Drehbewegung 3 ausgeführt werden.

Der erste Zapfen 11a weist eine erste Erhebung 41, eine zweite Erhebung 42 und eine Nut 43 auf. Die erste Erhebung 41 und die zweite Erhebung 42 sind derart auf dem ersten Zapfen 11a angeordnet, dass zwischen der ersten Erhebung 41 und der zweiten Erhebung 42 die Nut 43 parallel zur Drehachse 13 in der Mantelfläche des ersten Zapfens 11a angeordnet ist. Auf der Innenseite des zweiten Schenkels 22 der ersten Gabel 11b ist eine erste Gegenerhebung 51 und eine zweite Gegenerhebung 52 angeordnet. Bei einer Schwenkbewegung des zweiten Gehäuseteils 2 von dem ersten Gehäuseteil 1 weg, also beispielsweise ein Bewegen von der ersten Stellung 31 in die zweite Stellung 32 (siehe FIG 1) läuft die erste Gabel 11b um den ersten Zapfen 11a bis zur Erreichung der zweiten Stellung 32 herum, wobei sich die erste Erhebung 41 und die erste Gegenerhebung 51 gegenseitig annähern bis schließlich die erste Gegenerhebung 51 über die erste Erhebung 41 springen kann und damit hat der zweite Gehäuseteil 2 die zweite Stellung 32 erreicht.

Würde nun von dieser zweiten Stellung 32 die Schwenkbewegung bzw. die Drehbewegung 3 weitergeführt, so überspringt die erste Gegenerhebung 51 auch die zweite Erhebung 42 und quasi zeitgleich überspringt die zweite Gegenerhebung 52 die erste Erhebung 51, wodurch eine dritte Stellung des zweiten Gehäuseteils 2 erreicht wird.

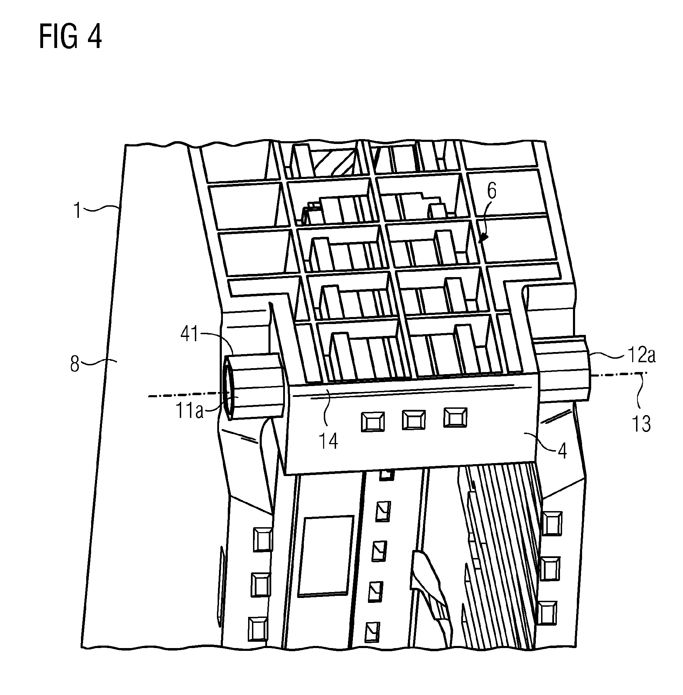

FIG 4 zeigt eine Detaildarstellung der Anordnung des ersten Zapfens 11a und des zweiten Zapfens 12a im Bereich der Kante 14 des ersten Gehäuseteils 1. Um durch das Anbringen einer schwenkbaren Frontklappe an ein Gehäuse für eine Automatisierungsbaugruppe einen zur Verfügung stehenden Bauraum nicht zu überschreiten, ist der erste Zapfen 11a und der zweite Zapfen 12a nach innen versetzt angeordnet. Die Drehachse 13 des Zapfengelenkes 10 verläuft parallel zu der Kante 14, wobei die Kante 14 durch die angrenzende Oberseite 6 an die Vorderseite 4 gebildet ist.

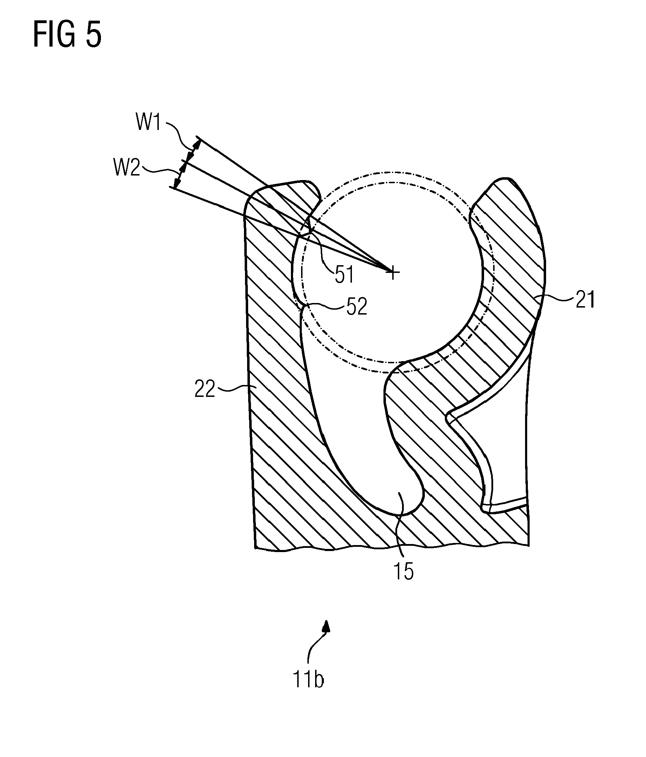

Gemäß FIG 5 ist eine mögliche Ausgestaltung einer Gabel am Beispiel der ersten Gabel 11b gezeigt. Die Gabel weist den ersten Schenkel 21 und den zweiten Schenkel 22 auf. Um bei einem Aufschnappen der Gabel auf den Zapfen einen vorgebbaren Dehnungswert des Gabel-Materials bei einer Spreizung der Schenkel 21,22 nicht zu überschreiten, weist die Gabel zusätzlich eine Materialausnehmung 15 auf.

Die erste Gegenerhebung 51 und die zweite Gegenerhebung 52 sind hintereinander auf der Schenkelinnenseite 21a auf dem zweiten Schenkel 22 angeordnet. Dabei sind die erste Gegenerhebung 51 und die zweite Gegenerhebung 52 derart ausgestaltet, dass eine Kraft zum Erreichen der zweiten Stellung 32 ausgehend von der ersten Stellung 31 kleiner ist als eine Kraft zum Erreichen der ersten Stellung 31 ausgehend von der zweiten Stellung 32. Dies wird dadurch erreicht, dass ein erster Winkel W1 größer ist als ein zweiter Winkel W2. Bezogen auf die Drehbewegung und dem anschließenden Überspringen der ersten Gegenerhebung 51 über die erste Erhebung 51 entspricht der erste Winkel W1 einem Anstieg bei dem Übersprung über die erste Erhebung 41 und der zweite Winkel W2 einem Heruntergleiten der ersten Gegenerhebung 51 auf der ersten Erhebung 41. Als vorteilhafte Winkelwerte haben sich für den ersten Winkel W1 = 55° und für den zweiten Winkel W2 = 45° herausgestellt.

Zusammenfassend kann gesagt werden, dass durch das Anbringen von Erhebungen an unterschiedlichen Positionen am Umfang des Zapfens sich die Möglichkeit ergibt, eine abnehmbare Frontklappe von einer beispielsweise geschlossenen Position in eine geöffnete Position zu bringen, wobei die durch die Rastmomente der Erhebungen bzw. Gegenerhebungen entstehenden Kräfte die Frontklappe auch in dieser Position gehalten wird.

## Patentansprüche

1. Gehäuse (100) mit einem ersten Gehäuseteil (1) und einem zweiten Gehäuseteil (2), aufweisend ein Zapfengelenk (10) mit einem Zapfen (11a) und eine den Zapfen (11a) zumindest teilweise umschließende Gabel (11b), wobei die Gabel (11b) einen ersten Schenkel (21) und einen zweiten Schenkel (22) aufweist, der Zapfen (11a) ist dabei am ersten Gehäuseteil (1) und die Gabel (11b) am zweiten Gehäuseteil (2) angeordnet,
**dadurch gekennzeichnet, dass** auf einer Mantelfläche des Zapfens (11a) eine Erhebung (41,42) und auf einer Schenkelinnenseite (21a) eines Schenkels (21,22) eine Gegenerhebung (51,52) derart angeordnet sind, dass der zweite Gehäuseteil (2) von einer ersten Stellung (31) in eine zweite Stellung (32) durch eine Drehbewegung (3) schwenkbar ist, wobei bei der Drehbewegung (3) die Gabel (11b) um den Zapfen (11a) zur Erreichung der zweiten Stellung (32) bewegbar ist, wobei die Erhebung (41,42) und die Gegenerhebung (51,52) sich gegenseitig annähern damit die Gegenerhebung (51,52) die Erhebung (41,42) überspringen kann und damit der zweite Gehäuseteil (2) die zweite Stellung (32) erreicht hat.

2. Gehäuse (100) nach Anspruch 1, wobei der erste Gehäuseteil (1)
- eine Vorderseite (4),
- eine Rückseite (5),
- eine Oberseite (6),
- eine Unterseite (7),
- eine erste Seitenwand (8) und
- eine zweite Seitenwand (9) aufweist,
wobei das Zapfengelenk (10) als ein erster Zapfen (11a) und ein zweiter Zapfen (12a) ausgestaltet ist, dabei sind der erste Zapfen (11a) und der zweite Zapfen (12a) auf einer Drehachse (13) gegenüberliegend angeordnet, die Drehachse (13) ist wiederum im Bereich einer Kante (14) angeordnet, welche durch die Angrenzung der Oberseite (6) an die Vorderseite (4) gebildet ist.

3. Gehäuse (100) nach Anspruch 1 oder 2, wobei am zweiten Gehäuseteil (2) eine erste Gabel (11b) und eine zweite Gabel (12b) angeordnet sind und die erste Gabel (11b) den ersten Zapfen (11a) zumindest teilweise umschließt und die zweite Gabel (12b) den zweiten Zapfen (12a) zumindest teilweise umschließt.

4. Gehäuse (100) nach einem der Ansprüche 1 bis 3, wobei die Erhebung (41,42) auf dem Zapfen (11a,12a) ausgehend von der Anordnung der Gabel (11b,12b) um den Zapfen (11a,12a) in der ersten Stellung (31) derart angeordnet ist, dass bei einer Schwenkbewegung des zweiten Gehäuseteils (2) von dem ersten Gehäuseteil (1) weg zur Erreichung der zweiten Stellung (32) sich ein Endpunkt von dem ersten Schenkel (21) von der Erhebung weg (41,42) bewegt und sich ein Endpunkt von dem zweiten Schenkel (22) auf die Erhebung (41,42) zu bewegt.

5. Gehäuse (100) nach einem der Ansprüche 1 bis 4, wobei eine erste Erhebung (41) und eine zweite Erhebung (42) auf dem Zapfen (11a,12a) angeordnet sind und zwischen der ersten Erhebung (41) und der zweiten Erhebung (42) eine Nut (43) parallel zur Drehachse (13) in der Mantelfläche des Zapfens (11a,12a) angeordnet ist.

6. Gehäuse (100) nach Anspruch 5, wobei die Erhebungen (41,42) als Spitznocken ausgestaltet sind.

7. Gehäuse (100) nach einem der Ansprüche 1 bis 6, wobei die Gegenerhebung (51,52) an der Schenkelinnenseite (21a) auf dem zweiten Schenkel (22) angeordnet ist.

8. Gehäuse (100) nach einem der Ansprüche 1 bis 7, wobei eine erste Gegenerhebung (51) und eine zweite Gegenerhebung (52) hintereinander an der Schenkelinnenseite (21a) auf dem zweiten Schenkel (32) angeordnet ist.

9. Gehäuse (100) nach einem der Ansprüche 1 bis 8, wobei die Gegenerhebung (51,52) derart ausgestaltet ist, dass eine Kraft zum Erreichen der zweiten Stellung (32) ausgehend von der ersten Stellung (31) kleiner ist als eine Kraft zum Erreichen der ersten Stellung (31) ausgehend von der zweiten Stellung (32).

10. Gehäuse (100) nach einem der Ansprüche 1 bis 9, wobei der zweite Gehäuseteil (2) als eine Frontklappe zum Abdecken der Vorderseite (4) ausgestaltet ist.

11. Gehäuse (100) nach einem der Ansprüche 1 bis 10, wobei die Gabel (11b,12b) eine Materialausnehmung (15) aufweist, um einen vorgebbaren Dehnungswert des Gabel-Materials bei einer Spreizung der Schenkel (21,22) nicht zu überschreiten.
